# EUROPEAN PATENT APPLICATION

(11) **EP 4 658 000 A1**
(43) Date of publication of application: **03.12.2025**
(21) Application number: 25151751.2
(22) Date of filing: 14.01.2025
(51) Int. Cl.: H05K 1/02, H05K 1/16, H01R 12/72, H01R 12/73, H01R 13/6464, H05K 1/11, H05K 1/14

(54) **CIRCUIT BOARD, SEMICONDUCTOR MODULE AND SEMICONDUCTOR SYSTEM**

(30) Priority: 28.05.2024 KR 20240069332
(71) Applicant: Samsung Electronics Co., Ltd., Suwon-si, Gyeonggi-do 16677 (KR)
(72) Inventor: LEE, Seungjin, 16677 Suwon-si, Gyeonggi-do (KR)
(74) Representative: Kuhnen & Wacker Patent- und Rechtsanwaltsbüro PartG mbB

(57) **Abstract**

A circuit board (100) includes: an insulating layer (110) configured to have a first surface (111) and a second surface (112) opposite to each other; first terminals (121) positioned on the first surface (111) of the insulating layer (110) and configured to include a first signal terminal (121S1) and a second signal terminal (121S2); and a first floating pattern (131) embedded in the insulating layer (110), configured to have a region overlapping each of the first signal terminal (121S1) and the second signal terminal (121S2), and electrically disconnected from the first signal terminal (121S1) and the second signal terminal (121S2).

## Description

### BACKGROUND

In a memory module, mutual inductance between signal terminals may cause far-end crosstalk (FEXT), which impairs signal integrity (SI) and interferes with high-speed operation of a product. Accordingly, methods to ameliorate the far-end crosstalk (FEXT) noise are being studied to improve the signal integrity (SI) of a memory module.

### SUMMARY

Some aspects of the present disclosure provide circuit boards, semiconductor modules, and semiconductor systems capable of ameliorating far-end crosstalk (FEXT) noise between signal terminals.

Some aspects of the present disclosure relate to a circuit board including: an insulating layer configured to have a first surface and a second surface opposite to each other; first terminals positioned on the first surface of the insulating layer and configured to include a first signal terminal and a second signal terminal; and a first floating pattern embedded in the insulating layer, configured to have a region overlapping the first signal terminal and a region overlapping the second signal terminal, and electrically disconnected from the first signal terminal and the second signal terminal.

Some aspects of the present disclosure relate to a semiconductor module including: a circuit board; and one or more semiconductor packages positioned on the circuit board, wherein the circuit board includes: an insulating layer configured to have a first surface and a second surface opposite to each other; first terminals positioned on the first surface of the insulating layer and configured to include a first signal terminal and a second signal terminal; and a first floating pattern embedded in the insulating layer, configured to have a region overlapping the first signal terminal and a region overlapping the second signal terminal, and electrically disconnected from the first signal terminal and the second signal terminal, and the first terminals are arranged in a first direction along one edge region of the circuit board.

Some aspects of the present disclosure relate to a semiconductor system including: a motherboard; a connector positioned on the motherboard; and a semiconductor module coupled to the connector and configured to include a circuit board and one or more semiconductor packages positioned on the circuit board. wherein the circuit board includes: an insulating layer configured to have a first surface and a second surface opposite to each other; terminals positioned on the first surface of the insulating layer and configured to include a first signal terminal and a second signal terminal; and a floating pattern embedded in the insulating layer, configured to have a region overlapping the first signal terminal and a region overlapping the second signal terminal, and electrically disconnected from the first signal terminal and the second signal terminal, and the terminals are arranged along one edge region of the circuit board to be inserted in the connector.

### BRIEF DESCRIPTION OF THE DRAWINGS

FIG. 1 is a perspective view of an example of a semiconductor system.
FIG. 2 is a cross-sectional view of an example of a semiconductor module.
FIG. 3 is a partial top plan view of an example of a semiconductor module.
FIG. 4 is a partial perspective view of an example of a circuit board.
FIG. 5 is a partial plan view of an example of a circuit board.
FIG. 6 is a partial cross-sectional view of an example of a circuit board.
FIG. 7 illustrates a partial layout of an example of a circuit board for semiconductor module design.
FIG. 8 illustrates examples of connection paths of signal terminals of FIG. 7.
FIG. 9 is a partial perspective view of an example of a circuit board.
FIG. 10 is a partial plan view of an example of a circuit board.
FIG. 11 is a partial layout of an example of a circuit board for semiconductor module design.
FIG. 12 is a partial perspective view of an example of a circuit board.
FIG. 13 is a partial cross-sectional view of an example of a circuit board.
FIG. 14 is a partial perspective view of a circuit board according to Comparative Example 1.
FIG. 15 illustrates a comparison of far-end crosstalk (FEXT) noise between signal terminals in Comparative Example 1 and another circuit board.
FIG. 16 illustrates simulation results of mutual capacitance between signal terminals as a function of a width of a floating pattern in a circuit board as illustrated in FIG. 4.
FIG. 17 illustrates simulation results of mutual capacitance between signal terminals as a function of a width of a floating pattern in a circuit board as illustrated in FIG. 9.
FIG. 18 illustrates simulation results of mutual capacitance between signal terminals in a circuit board as illustrated in FIG. 12.
FIG. 19 is a perspective view showing a partial layout of a circuit board according to Comparative Example 2.
FIG. 20 is a perspective view showing a partial layout of a circuit board according to Example 1.
FIG. 21 is a perspective view showing a partial layout of a circuit board according to Example 2.
FIG. 22 and FIG. 23 are eye diagrams of examples of circuit boards.
FIGS. 24-27 illustrates regions of a semiconductor module to which a floating pattern can be applied.

### DETAILED DESCRIPTION

The present disclosure will be described more fully hereinafter with reference to the accompanying drawings, in which various examples are shown. It will be understood that the described examples may be modified in various ways without departing from the scope of the present disclosure.

Like numerals refer to like or similar components throughout the specification.

Further, since sizes and thicknesses of constituent members shown in the accompanying drawings are arbitrarily given for better understanding and ease of description, the present disclosure is not limited to the illustrated sizes and thicknesses. In the drawings, the thicknesses of layers, films, panels, regions, etc., are exaggerated for clarity. In the drawings, for better understanding and ease of description, the thicknesses of some layers and areas are exaggerated.

Throughout this specification and the claims that follow, when it is described that an element is "coupled/connected" to another element, the element may be "directly coupled/connected" to the other element or "indirectly coupled/connected" to the other element through a third element. In a similar sense, this includes being "physically connected" as well as being "electrically connected".

It will be understood that when an element such as a layer, film, region, or substrate is referred to as being "on" another element, it can be directly on the other element or intervening elements may also be present. In contrast, when an element is referred to as being "directly on" another element, there are no intervening elements present. Further, in the specification, the word "on" or "above" means positioned on or below the object portion, and does not necessarily mean positioned on the upper side of the object portion based on a gravitational direction.

In addition, unless explicitly described to the contrary, the word "comprise" and variations such as "comprises" or "comprising" will be understood to imply the inclusion of stated elements but not the exclusion of any other elements.

Further, throughout the specification, the phrase "in a plan view" means when an object portion is viewed from above, and the phrase "in a cross-sectional view" means when a cross-section taken by vertically cutting an object portion is viewed from the side.

In addition, throughout the specification, sequence numbers such as first, second, etc. are used to distinguish a certain component from other components that are the same or similar thereto, and are not necessarily intended to refer to a specific component. Accordingly, a component referred to as a first component in a specific part of this specification may be referred to as a second component in other parts of this specification.

In addition, throughout the specification, singular references to certain elements include references to a plurality of these elements, unless specifically stated to the contrary.

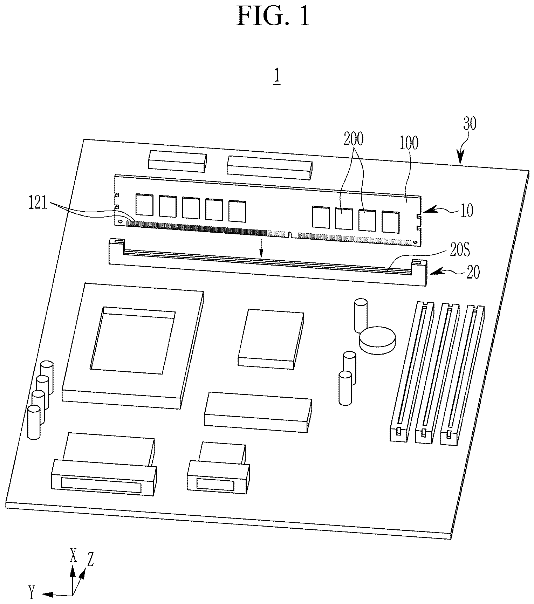

FIG. 1 illustrates a perspective view of a semiconductor system. The semiconductor system 1 includes a motherboard 30, a connector 20 positioned on the motherboard 30, and a semiconductor module 10 coupled to the connector 20.

The motherboard 30 may connect major components mounted thereon to each other, and may provide an interface between the major components and peripheral devices. The motherboard 30 may be referred to as a main board, a major board, a system board, etc. In addition to the semiconductor module 10, other components such as a CPU, a GPU, a co-processor, a chipset, a peripheral component interconnect (PCI), and a power connector may be further mounted on the motherboard 30.

The connector 20 for mounting the semiconductor module 10 may be positioned on the motherboard 30. The connector 20 may support the semiconductor module 10, and may provide an electrical connection between the semiconductor module 10 and the motherboard 30. The connector 20 may have a slot 20S, and the semiconductor module 10 may be accommodated in the connector 20 by inserting a first end portion of the semiconductor module 10 on which first terminals 121 are positioned into the slot 20S. Pins electrically connected to the first terminals 121 may be positioned on an inner surface of the slot 20S of the connector 20. The pins may be placed at positions corresponding to the first terminals 121 so as to contact the first terminals 121.

The semiconductor module 10 may include a memory module. The memory module may include at least one of a dual inline memory module (DIMM), a small outline dual inline memory module (SODIMM), an unbuffered dual inline memory module (UDIMM), a registered dual inline memory module (RDIMM), a load reduced dual inline memory module (LRDIMM), a hypercloud dual inline memory module (HDIMM), an nonvolatile DIMM (NVDIMM), a fully buffered dual inline memory module (FB-DIMM), a CXL memory module (CMM), a multi-ranked buffered DIMM (MRDIMM), or a low power compression attached memory module (LPCAMM).

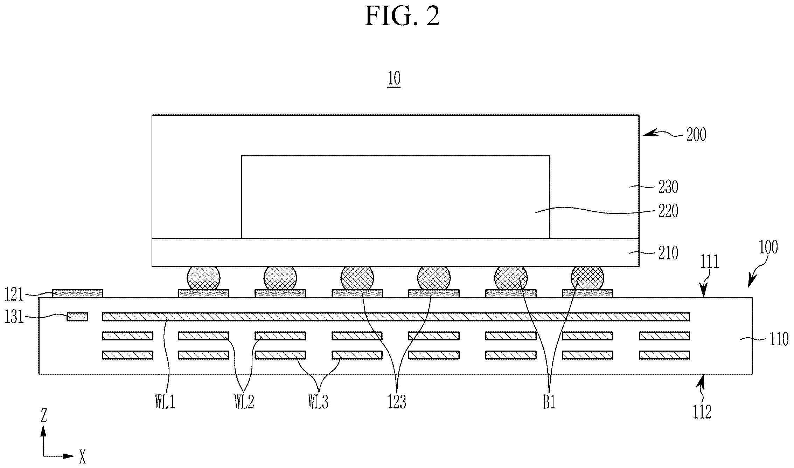

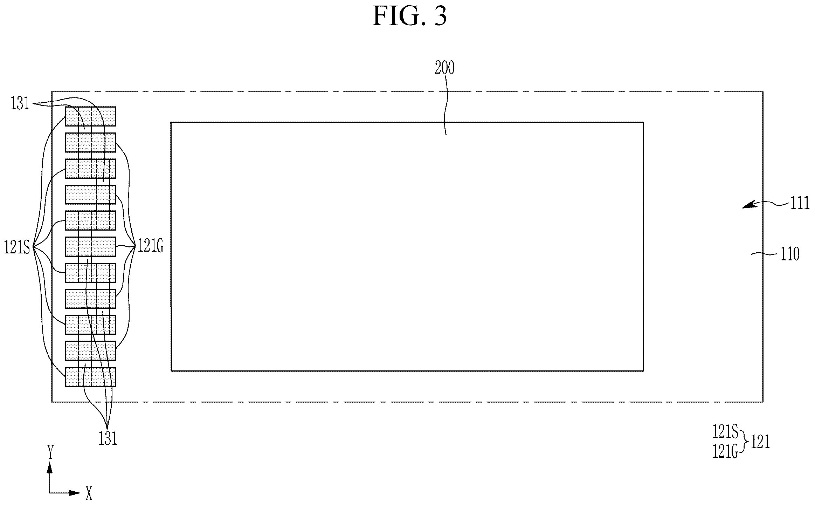

Hereinafter, the semiconductor module 10 according to the present disclosure that can be applied to the semiconductor system 1 will be described in more detail. FIG. 2 illustrates a cross-sectional view of a semiconductor module (e.g., semiconductor module 10), and FIG. 3 illustrates a partial top plan view of a semiconductor module (e.g., semiconductor module 10).

The semiconductor module 10 may include a circuit board 100 and one or more semiconductor packages 200 arranged on the circuit board 100. For a clear illustration of the main components, FIG. 3 shows only some regions where one semiconductor package 200 of the semiconductor module 10 is positioned.

The circuit board 100 may include an insulating layer 110 having a first surface 111 and a second surface 112 that are opposite to each other, first terminals 121 and pads 123 positioned on the first surface 111 of the insulating layer 110, and one or more floating patterns 131 embedded in the insulating layer 110.

A plurality of internal wiring layers WL1, WL2, and WL3 may be positioned inside the insulating layer 110, and the insulating layer 110 may insulate the internal wiring layers WL1, WL2, and WL3 from each other. A number of insulating layers 110 is not particularly limited and may vary depending on a number of internal wiring layers WL1, WL2, and WL3. When the insulating layer 110 is formed to include a plurality of insulating layers, the insulating layers may have boundaries with each other or may not have boundaries that can be seen with the naked eye. An insulating material may be used as a material for the insulating layer 110, e.g., polyimide (PI), epoxy, FR-4, FR-2, a photoimageable dielectric (PID) material, etc.

The internal wiring layers WL1, WL2, and WL3 may be electrically connected to each other through vias. Additionally, or alternatively, the internal wiring layers WL1, WL2, and WL3 may be electrically connected to the first terminals 121 and the pads 123. The internal wiring layers WL1, WL2, and WL3 may perform various functions depending on the design, and may include signal patterns, power patterns, ground patterns, etc. The number of the internal wiring layers WL1, WL2, and WL3 is not limited to the number shown in the drawing, and may be implemented as various numbers in various implementations. Conductive materials may be used as materials for the internal wiring layers WL1, WL2, and WL3. For example, aluminum (Al), copper (Cu), gold (Au), platinum (Pt), silver (Ag), tin (Sn), chromium (Cr), palladium (Pd), or an alloy of two or more among them may be used.

The first terminals 121 may be arranged in a Y direction along or in one edge region of the circuit board 100 on the first surface 111 of the insulating layer 110. The first terminals 121 may be disposed to protrude on the first surface 111 of the insulating layer 110, and at least a portion of the first terminals 121 may be embedded in the insulating layer 110 and an upper surface of the first terminals 121 may be exposed by the first surface 111 of the insulating layer 110. The first terminals 121 may be spaced apart by a predetermined distance along the Y direction. The first terminals 121 may be accommodated in the connector 20 to provide an electrical connection between the semiconductor module 10 and the connector 20. The first terminals 121 may be referred to as gold fingers, edge connectors, connector pins, tab terminals, etc. A length of the first terminal 121 in the X direction may be longer than a length in the Y direction.

As a material for the first terminal 121, a material with high electrical conductivity and excellent chemical stability, such as gold (Au), may be used. However, the material of the first terminal 121 is not limited to gold, and another conductive material may be used as the material of the first terminal 121.

The first terminals 121 may include signal terminals 121S and ground terminals 121G. The signal terminals 121S may be electrically connected to a circuit that performs a signal transmission function of the circuit board 100, and the ground terminals 121G may be electrically connected to a circuit that performs a ground function of the circuit board 100. The signal terminals 121S and the ground terminals 121G may be alternately arranged in the Y direction along or in one edge region of the circuit board 100. For example, the ground terminals 121G may be positioned between two adjacent signal terminals 121S.

The pads 123 may be positioned on the first surface 111 of the insulating layer 110 to electrically connect the circuit board 100 to the semiconductor package 200. Conductive materials may be used as a material for the pad 123, and for example, aluminum (Al), copper (Cu), gold (Au), platinum (Pt), silver (Ag), tin (Sn), chromium (Cr), palladium (Pd), or an alloy of two or more among them may be used.

In some implementations, a passivation layer is disposed on the first surface 111 of the insulating layer 110, and the first terminals 121 and the pads 123 may be exposed on or by an upper surface of the passivation layer.

As shown in FIGS. 2-3, the circuit board 100 includes one or more floating patterns 131 that compensate for mutual capacitance between two or more signal terminals 121S. The floating pattern 131 may be embedded in the insulating layer 110, and may have a region overlapping the signal terminals 121S to provide compensation for mutual capacitance. In the present disclosure, 'overlap' indicates overlap in the Z direction, e.g., when viewed in a plan view.

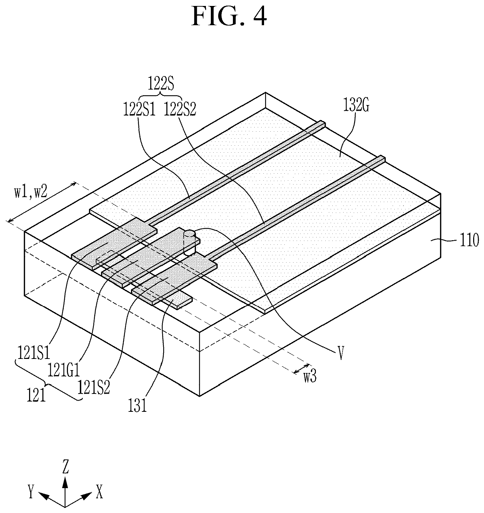

A number of floating patterns 131 included in the circuit board 100 may vary depending on the implementations. In some implementations, all the signal terminals 121S included in the circuit board 100 have a region that overlaps a floating pattern 131. For example, as shown in FIG. 3, the circuit board 100 may include a plurality of floating patterns 131, each of which may have regions that overlap adjacent signal terminals 121S among the signal terminals 121S. In some implementations, some signal terminals 121S have a region that overlaps a floating pattern 131, and some signal terminals 121S do not have a region that overlaps the floating pattern 131. Additional description of the floating pattern 131 will be provided in reference to FIGS. 4 to 6.

A plurality of semiconductor packages 200 may be arranged on the circuit board 100. For example, the semiconductor packages 200 may be arranged on the circuit board 100 and spaced apart from each other in the Y direction. However, a number of semiconductor packages 200 positioned on the circuit board 100 is not particularly limited, and in some implementations only a single semiconductor package 200 is positioned on the circuit board 100.

Each of the semiconductor packages 200 may be spaced apart from the first terminals 121 of the circuit board 100 in the X direction.

Each semiconductor package 200 may be mounted on the circuit board 100 through a conductive bump B1. The conductive bump B1 may be positioned between the semiconductor package 200 and the pads 123 of the circuit board 100. The conductive bump B1 may be formed of a conductive material, e.g., a solder ball.

The semiconductor package 200 may include a substrate 210, a semiconductor chip 220 positioned on the substrate 210, and a molding material 230 for molding the semiconductor chip 220.

The substrate 210 may be a multilayer substrate including a plurality of insulating layers and a plurality of wiring layers. Pads may be positioned on upper and lower surfaces of the substrate 210 to electrically connect the substrate 210 to other components. Additionally, a passivation layer may be positioned on the upper and lower surfaces of the substrate 210, and the pads of the substrate 210 may be exposed with the passivation layer.

In some implementations (e.g., when the semiconductor module 10 includes a memory module), the semiconductor chip 220 includes a memory chip. The memory chip may include one or more of a dynamic random access memory (DRAM) chip, a static random access memory (SRAM) chip, a flash memory chip, a high bandwidth memory (HBM) chip, a read-only memory (ROM) chip, and a magnetic random access memory (MRAM) chip.

The molding material 230 may serve to physically and chemically protect the semiconductor chip 220. The molding material 230 may be made of an insulating material such as epoxy molding compound (EMC). Compression molding, transfer molding, etc. may be used as a method of forming the molding material 230.

Hereinafter, a layout of the floating pattern 131 and its adjacent components will be described with reference to FIGS. 4 to 6.

FIGS. 4, 5, and 6 illustrate partial perspective, partial plan, and partial cross-sectional views, respectively, of a circuit board such as the circuit board 100.

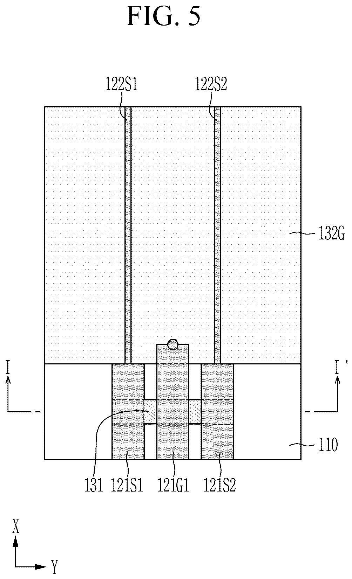

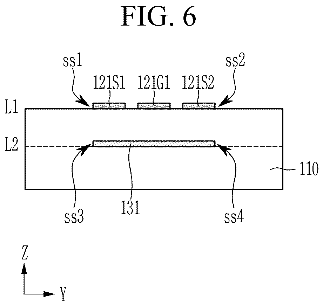

FIG. 6 shows a view of FIG. 5 cut along I-I'.

To clearly show certain components, the insulating layer 110 is assumed to be transparent in each drawing. In addition, in a following description, among the signal terminals 121S, signal terminals overlapping the floating pattern 131 are respectively referred to as a first signal terminal 121S1 and a second signal terminal 121S2, and among the ground terminals 121G, the ground terminal 121G disposed between the first signal terminal 121S1 and the second signal terminal 121S2 is referred to as a first ground terminal 121G1.

According to some implementations, far-end crosstalk is reduced by introducing the floating pattern 131 that is not electrically connected to some components, or to any component, within the circuit board 100 (e.g., that is electrically disconnected from some or all other components of the circuit board 100) and creating an appropriate mutual capacitance between adjacent signal terminals.

The floating pattern 131 has a region overlapping the first signal terminal 121S1 and a region overlapping the second signal terminal 121S2. For example, the floating pattern 131 may be positioned below lower surfaces of the first signal terminal 121S1 and the second signal terminal 121S2 to have regions that overlap them. The first signal terminal 121S1 and the second signal terminal 121S2 may be adjacent signal terminals 121S among the signal terminals 121S. In some implementations, the floating pattern 131 has region(s) that overlap additional signal terminal(s) in addition to the first signal terminal 121S1 and the second signal terminal 121S2.

The floating pattern 131 may extend in the Y direction from the first signal terminal 121S1 to the second signal terminal 121S2. A length of the floating pattern 131 in the Y direction may be longer than a length in the X direction (length in a width direction).

The first signal terminal 121S1 and the second signal terminal 121S2 are spaced apart in the Y direction, and the first ground terminal 121G1 may be positioned therebetween. Accordingly, the first ground terminal 121G1 positioned between the first signal terminal 121S1 and the second signal terminal 121S2 may also have a region overlapping the floating pattern 131.

Referring to FIG. 6, a first side surface ss3 of opposite side surfaces ss3 and ss4 facing in the Y direction of floating pattern 131 may overlap (e.g., be aligned with) side surface ss1 farthest from the second signal terminal 121S2 among opposite side surfaces facing in the Y direction of the first signal terminal 121S1, or may be arranged further outward in the Y direction (to the left in FIG. 6). Similarly, a second side surface ss4 of opposite side surfaces ss3 and ss4 facing in the Y direction of floating pattern 131 may overlap (e.g., be aligned with) side surface ss2 farthest from the first signal terminal 121S1 among opposite side surfaces facing in the Y direction of the second signal terminal 121S2, or may be arranged further outward in the Y direction (to the right in FIG. 6). In some implementations, a high target level of mutual capacitance between the floating pattern 131 and the signal terminals 121S is obtained through a structure in which the floating pattern 131 overlaps an entire region of each of the signal terminals 121S1 and 121S2 in a cross-sectional view, e.g., extends entirely across each of the signal terminals 121S1 and 121S2 in the Y direction.

The floating pattern 131 may be electrically disconnected from the wiring of the circuit board 100 (e.g., the internal wiring layers WL1, WL2, and WL3 of FIG. 2). For example, the floating pattern 131 may not be electrically connected to any wire of the circuit board 100. For example, the floating pattern 131 may be electrically disconnected from the signal terminal 121S and the ground terminal 121G of the circuit board 100. As the floating pattern 131 is electrically disconnected from other components, an outer surface of the floating pattern 131 may be covered with the insulating layer 110. The outer surface of the floating pattern 131 includes all of an upper surface, a lower surface, and side surface(s) connecting the upper surface and the lower surface. As the floating pattern 131 is electrically disconnected from the wires of the circuit board 100, the floating pattern 131 may not affect existing wires, and may generate mutual capacitance between signal terminals without being associated with increased time and/or cost of more drastic design changes.

A width w3 of the floating pattern 131 may be equal to or narrower than a width w1 of the first signal terminal 121S1 and a width w2 of the second signal terminal 121S2. In this specification, a width of a certain element is defined as a length of the certain element in the X direction. For example, if the width w1 of the first signal terminal 121S1 and the width w2 of the second signal terminal 121S2 are about 1.85 mm according to the standard specifications, the width w3 of the floating pattern 131 may be a maximum of about 1.85 mm, e.g., 1.85 mm or less. As the width w3 of the floating pattern 131 is equal to or narrower than each of the width w1 of the first signal terminal 121S1 and the width w2 of the second signal terminal 121S2, a wiring space may be prevented from being restricted due to the floating pattern 131.

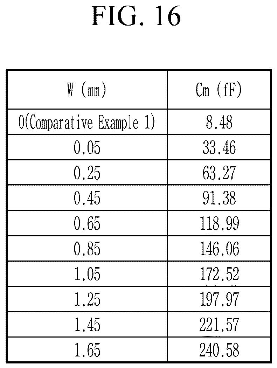

Referring to FIG. 16, it may be seen that as the width w3 (or W) of floating pattern 131 increases, the mutual capacitance Cm between the first signal terminal 121S1 and the second signal terminal 121S2 increases. When the width w3 of the floating pattern 131 is formed to be equal to each of the width w1 of the first signal terminal 121S1 and the width w2 of the second signal terminal 121S2, mutual capacitance between the signal terminals 121S1 and 121S2 may be maximized without limiting wiring space.

Referring to FIG. 2, the circuit board 100 may include a plurality of internal wiring layers WL1, WL2, and WL3 embedded in the insulating layer 110. The floating pattern 131 may be positioned at a same level as the internal wiring layer WL1 (hereinafter referred to as an uppermost internal wiring layer) that is closest to the first terminals 121 among the internal wiring layers WL1, WL2, and WL3. Accordingly, an internal wiring layer may not exist between a level L1 where the first terminals 121 are positioned and a level L2 where the floating pattern 131 is positioned. In the present disclosure, the level refers to a level in the Z direction, and, in the drawings, the level is indicated based on a lower surface of each component. As the floating pattern 131 is positioned at the same level as the uppermost internal wiring layer WL1 among the internal wiring layers WL1, WL2, and WL3, mutual capacitance can be maximized by minimizing a distance between the floating pattern 131 and the first terminals 121. The internal wiring layers WL1, WL2, and WL3 embedded in the insulating layer 110 may be spaced apart from the floating pattern 131 in the X direction in a plan view, and may not overlap with the floating pattern 131. A sufficient wiring space may be secured by forming the floating pattern 131 at an edge portion of the circuit board 100 to be spaced apart from the internal wiring layers WL1, WL2, and WL3.

However, the floating pattern 131 is not limited to being designed to maximize the mutual capacitance between the signal terminals 121S, and mutual capacitance to be created between the signal terminals 121S may vary depending on the implementation. A level at which the floating pattern 131 is positioned may be appropriately adjusted depending on a target mutual capacitance value to be generated between the signal terminals 121S. For example, the floating pattern 131 may be positioned at the same level as a wiring layer (e.g., the internal wiring layer WL2) other than the uppermost internal wiring layer WL1 among the internal wiring layers WL1, WL2, and WL3. In addition, depending on the mutual capacitance value to be created between the signal terminals 121S, a shape and size of the floating pattern 131, an area overlapping the signal terminals 121S, the distance between the signal terminals 121S, etc. may also be appropriately determined.

Conductive materials may be used as a material for the floating pattern 131, and for example, aluminum (Al), copper (Cu), gold (Au), platinum (Pt), silver (Ag), tin (Sn), chromium (Cr), palladium (Pd), or an alloy of two or more among them may be used. The material of the floating pattern 131 may be the same as that of the internal wiring layers WL1, WL2, and WL3 embedded in the insulating layer 110, and the floating pattern 131 and the internal wiring layers WL1, WL2, and WL3 may be formed through a same process, thereby simplifying the process.

The first signal terminal 121S1 and the second signal terminal 121S2 may be connected to a first signal wire 122S1 and a second signal wire 122S2, respectively. The first signal terminal 121S1 may be connected to the first signal wire 122S1 and other component(s) connected thereto to form a path for transmitting a first signal, and the second signal terminal 121S2 may be connected to the second signal wire 122S2 and other component(s) connected thereto to form a path for transmitting a second signal.

The circuit board 100 may further include a ground plane 132G positioned at a same level L2 as the floating pattern 131 and spaced apart from the floating pattern 131, and electrically connected to the first ground terminal 121G1 through a via V. The ground plane 132G may be included in the internal wiring layer WL1 embedded in the insulating layer 110. For example, the ground plane 132G may be spaced apart from the floating pattern 131 in the X direction, and may be a large-area pattern with a relatively large area. As the first ground terminal 121G1 is electrically disconnected from the floating pattern 131, it will be understood that the ground plane 132G may also be electrically disconnected from the floating pattern 131.

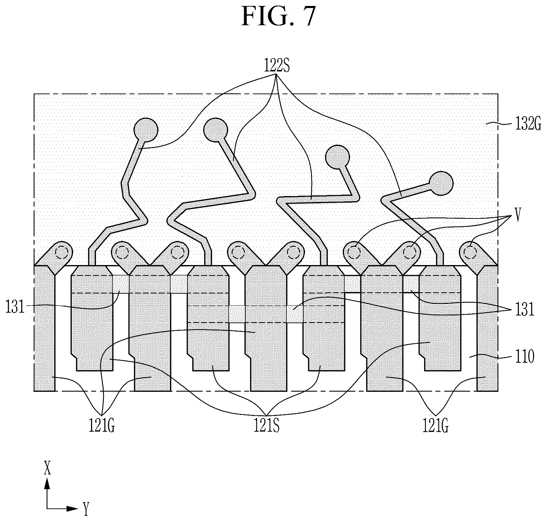

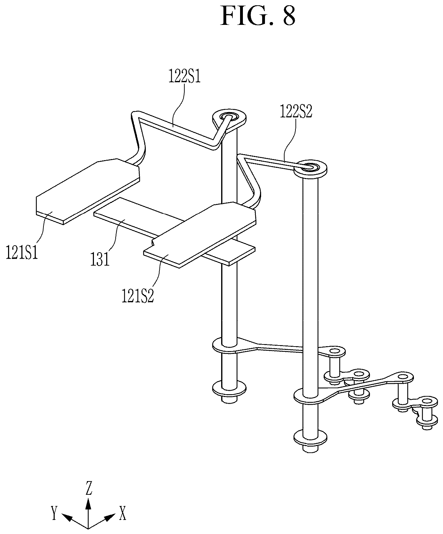

FIG. 7 illustrates a partial layout of a circuit board for semiconductor module design. FIG. 8 illustrates some connection paths of signal terminals of FIG. 7.

As described above, the first terminals 121 may include signal terminals 121S and ground terminals 121G, and the signal terminals 121S and the ground terminals 121G may be alternately arranged in the Y direction along or in one edge region of the circuit board 100. In this case, each of the floating patterns 131 may extend in the Y direction between adjacent signal terminals 121S, to overlap the adjacent signal terminals 121S and the ground terminal 121G positioned therebetween.

In some implementations, at least some of the signal terminals 121S overlap a plurality (e.g., two) of the floating patterns 131. A plurality of floating patterns 131 overlapping one signal terminal 121S may generate mutual capacitance between the signal terminal 121S and each of the other signal terminals 121S positioned at opposite sides of the signal terminal 121S. Far-end crosstalk caused by signals transmitted from opposite sides of the signal terminal 121S may be reduced or effectively eliminated by creating a mutual capacitance between the signal terminal 121S and each of the other signal terminals 121S positioned at opposite sides thereof.

Floating patterns 131 adjacent to each other in the Y direction may be arranged to be offset from each other in the X direction X in order to efficiently arrange the floating patterns 131 overlapping each signal terminal 121S and maximize an area where the floating patterns 131 and the signal terminals 121S overlap. For example, the floating patterns 131 adjacent to each other in the Y direction may be alternately arranged in opposite positions in the X direction to form a zigzag shape.

Referring to FIG. 8, the first signal terminal 121S1 and the second signal terminal 121S2 may each be connected to other components of the circuit board 100 to form independent signal paths. For example, the first signal terminal 121S1 may be connected to the first signal wire 122S1 to form a path for transmitting a first signal, and the second signal terminal 121S2 may be connected to the second signal wire 122S2 to form a path for transmitting a second signal. To form a signal path, the first signal wire 122S1 and the second signal wire 122S2 may be electrically connected to signal wires positioned at other layers through vias, respectively.

According to some implementations of the present disclosure, mutual capacitance between signal terminals may be created or increased without affecting existing wires and without increasing a time and cost of additional design changes by forming a floating pattern 131 that overlaps the first signal terminal 121S1 and the second signal terminal 121S2 and is electrically disconnected from the wires of the circuit board 100, e.g., is electrically disconnected from the first signal terminal 121S1 and the second signal terminal 121S2, including any wires connected thereto.

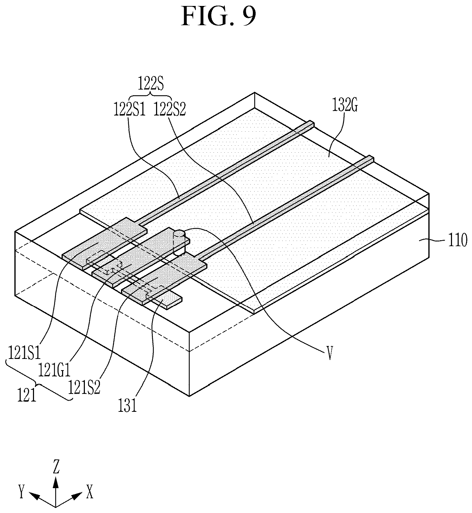

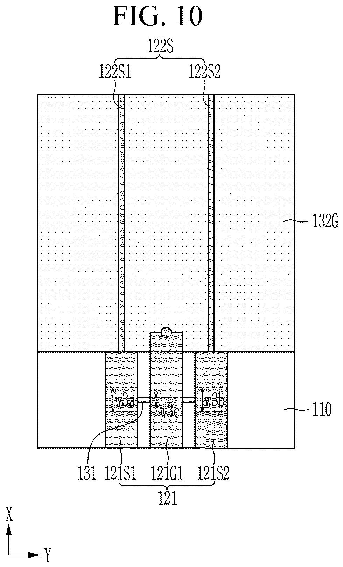

FIGS. 9 and 10 illustrate partial perspective and partial plan views of another example of a circuit board, respectively. Compared to the example of FIGS. 4 to 6, the floating pattern 131 of FIGS. 9 and 10 includes regions with different widths.

For example, as shown in FIGS. 9 and 10, a width w3c of the floating pattern 131 in a region overlapping the first ground terminal 121G1 may be narrower than each of a width w3a of the floating pattern 131 in a region overlapping the first signal terminal 121S1 and a width w3b of the floating pattern 131 in a region overlapping the second signal terminal 121S2. The width w3a in the region overlapping the first signal terminal 121S1 and the width w3b in the region overlapping the second signal terminal 121S2 may be the same as or different from each other.

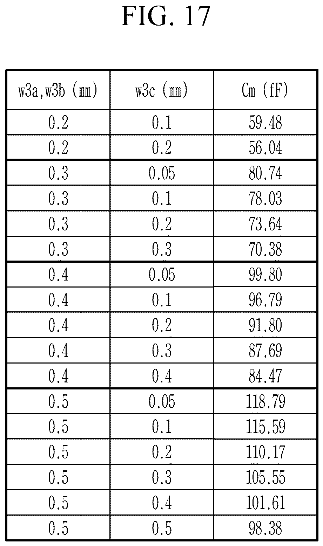

Referring to FIG. 17, it may be seen that, under a condition that the widths w3a and w3b in the regions overlapping the signal terminals 121S1 and 121S2 are constant, as the width w3c of the region overlapping the first ground terminal 121G1 becomes narrower, the mutual capacitance between the first signal terminal 121S1 and the second signal terminal 121S2 increases.

When forming the width w3c of the floating pattern 131 narrow in the region overlapping the first ground terminal 121G1, mutual capacitance between the first signal terminal 121S1 and the second signal terminal 121S2 may be further increased by reducing capacitance generated between the floating pattern 131 and the first ground terminal 121G1.

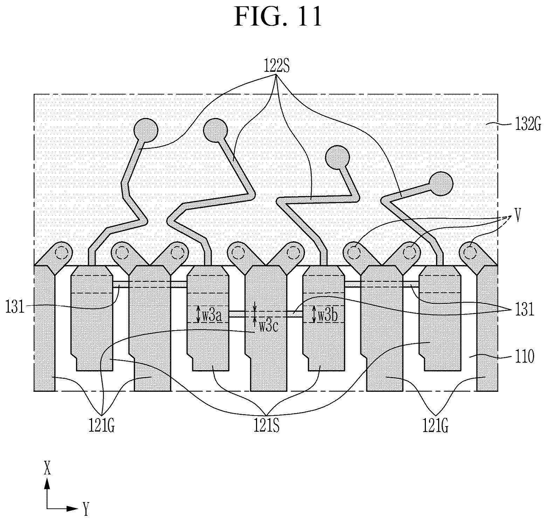

FIG. 11 illustrates a partial layout for designing a circuit board according to the configuration of FIGS. 9 and 10. Compared to the circuit board shown in FIG. 7, the width w3c of the floating pattern 131 in the region overlapping the first ground terminal 121G1 may be narrower than each of the width w3a in the region overlapping the first signal terminal 121S1 and the width w3b in the region overlapping the second signal terminal 121S2.

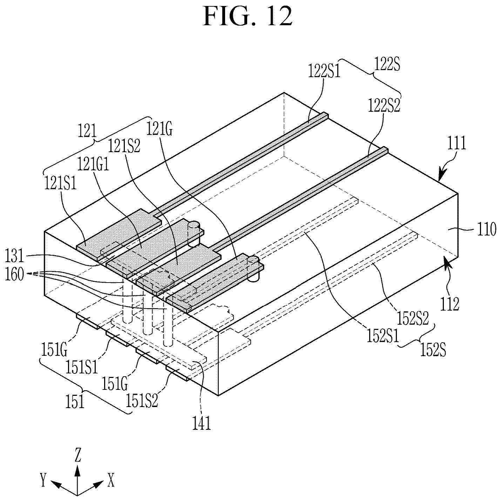

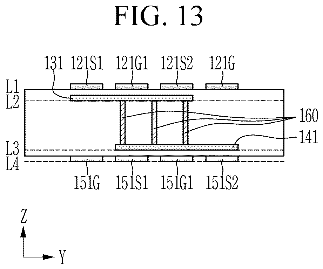

FIGS. 12 and 13 illustrate partial perspective and partial cross-sectional views of another example of a circuit board. Compared to the example of FIGS. 4 to 6, the circuit board 100 of FIGS. 12 and 13 further includes second terminals 151 positioned on the second surface 112 of the insulating layer 110 and an additional floating pattern 141 embedded in the insulating layer 110.

The second terminals 151 may be arranged in the Y direction along or in one edge region of the circuit board 100 on the second surface 112 of the insulating layer 110. The second terminals 151 may be at positions that overlap the first terminals 121.

Except where noted otherwise or suggested otherwise by context, the description of the first terminals 121 may be applied equally as a description of the second terminals 151. For example, the second terminals 151 may include signal terminals 151S and ground terminals 151G like the first terminals 121, and the signal terminals 151S and the ground terminals 151G may be alternately arranged in the Y direction along or in one edge region of the circuit board 100.

The signal terminals 151S of the second terminals 151 may each overlap the ground terminals 121G of the first terminals 121, and the ground terminals 151G of the second terminals 151 may each overlap the signal terminals 121S of the first terminals 121. However, their relative positions are not limited thereto.

In the following description, among the signal terminals 151S, the signal terminals 151S that overlap the second floating pattern 141 are respectively referred to as a third signal terminal 151S1 and a fourth signal terminal 151S2, and among the ground terminals 151G, the ground terminal 151G positioned between the third signal terminal 151S1 and the fourth signal terminal 151S2 is referred to as a second ground terminal 151G1. In addition, in order to distinguish between the floating patterns 131 and 141 positioned at opposite sides of the insulating layer 110, the floating pattern 131 positioned on (e.g., closest to) the first surface 111 of the insulating layer 110 is referred to as a first floating pattern 131, and the floating pattern 131 positioned on (e.g., closest to) the second surface 112 of the insulating layer 110 is referred to as a second floating pattern 141.

The third signal terminal 151S1 and the fourth signal terminal 151S2 may be connected to a third signal wire 152S1 and a fourth signal wire 152S2, respectively. The third signal terminal 151S1 may be connected to the third signal wire 152S1 and other component(s) connected thereto to form a path for transmitting a third signal, and the fourth signal terminal 151S2 may be connected to the fourth signal wire 152S2 and other component(s) connected thereto to form a path for transmitting a fourth signal.

Except where noted otherwise or suggested otherwise by context, the description of the first floating pattern 131 may be applied equally as a description of the second floating pattern 141. For example, the second floating pattern 141 may have a region overlapping the third signal terminal 151S1 and a region overlapping the fourth signal terminal 151S2, and may also have a region overlapping the second ground terminal 151G1 positioned therebetween. Additionally, the second floating pattern 141 may be electrically disconnected from other wires of the circuit board 100, including the third signal terminal 151S1 and the fourth signal terminal 151S2.

The second floating pattern 141 may be positioned at the level L3 between the first floating pattern 131 and the second terminals 151 so as to be adjacent to the second terminals 151. For example, the second floating pattern 141 may be positioned at a same level as the internal wiring layer closest to the second terminals 151 among the internal wiring layers embedded in the insulating layer 110. Accordingly, an internal wiring layer may not exist between a level L4 where the second terminals 151 are positioned and a level L3 where the second floating pattern 141 is positioned. Internal wiring layer(s) may exist between the level L2 where the first floating pattern 131 is positioned and the level L3 where the second floating pattern 141 is positioned. It will be understood that other positions of the second floating pattern 141 are within the scope of this disclosure.

The circuit board 100 or components thereof may be embedded in the insulating layer 110, and may further include one or more vias 160 electrically connecting the first floating pattern 131 and the second floating pattern 141. The vias 160 may integrally penetrate and extend through the insulating layer 110 between the level L2 where the first floating pattern 131 is positioned and the level L3 where the second floating pattern 141 is positioned. The vias 160 may overlap both the first floating pattern 131 and the second floating pattern 141. A number of vias 160 is not particularly limited and may be single or plural. The shape of the via 160 may also be not particularly limited, and may have a cylindrical shape, a tapered shape in which the cross-sectional area narrows from one side to the other, an hourglass shape, etc.

In a semiconductor module such as a dual inline memory module (DIMM), the first floating pattern 131 and the second floating pattern 141 may generate mutual capacitance between signal electrodes positioned at opposite sides of the insulating layer 110, to effectively improve far-end crosstalk noise that may occur between multiple signal electrodes.

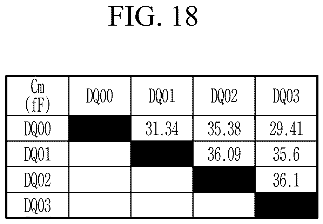

In FIG. 18, DQ00, DQ01, DQ02, and DQ03 represent the first signal terminal 121S1, the second signal terminal 121S2, the third signal terminal 151S1, and the fourth signal terminal 151S2, which are signal terminals for transmitting and/or receiving data, respectively. Referring to FIG. 18, simulation results confirm that mutual capacitance Cm is generated between each of the first signal terminal 121S1, the second signal terminal 121S2, the third signal terminal 151S1, and the fourth signal terminal 151S2.

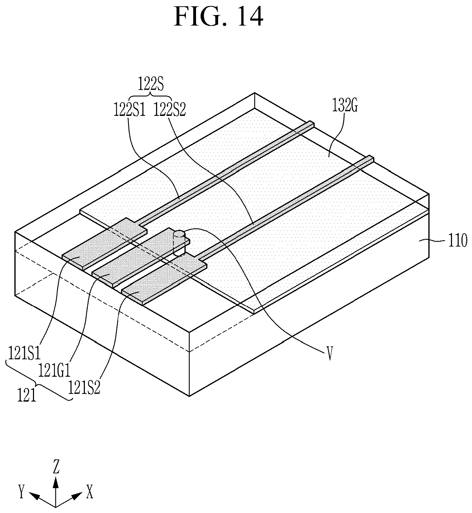

FIG. 14 illustrates a partial perspective view of a circuit board according to Comparative Example 1. The circuit board according to Comparative Example 1 does not include the floating pattern 131 that overlaps the signal terminals.

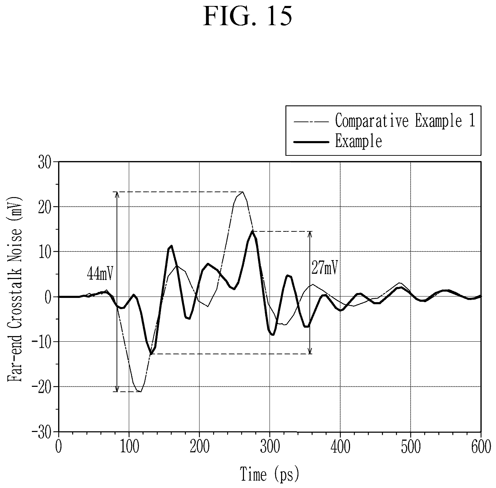

FIG. 15 illustrates a comparison between far-end crosstalk (FEXT) noise between signal terminals in Comparative Example 1 and an example that does include the floating pattern 131. Referring to FIG. 15, it may be seen from simulation results that the far-end crosstalk noise between signal terminals is significantly reduced from 44 mV (without the floating pattern) to 27 mV (with the floating pattern 131).

In addition, referring to FIG. 16, it may be seen from simulation results that the mutual capacitance between the first signal terminal 121S1 and the second signal terminal 121S2 is insignificant at 8.48 fF in Comparative Example 1 without a floating pattern, but increases to about 240.58 fF in the case of the example with the floating pattern 131 (structure in FIG. 4). As such, it can be seen that the floating pattern 131 creates an appropriate mutual capacitance between signal terminals, thereby reducing the far-end crosstalk noise between the signal terminals.

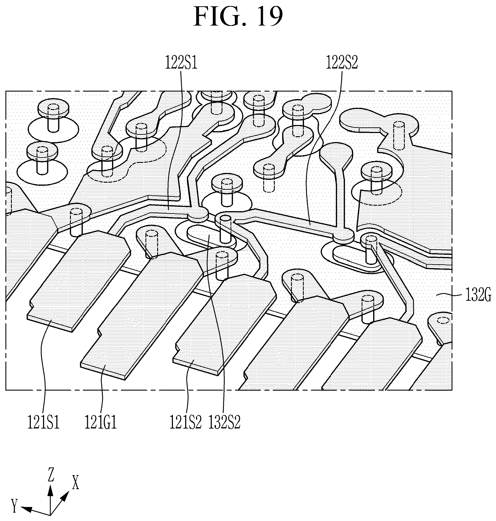

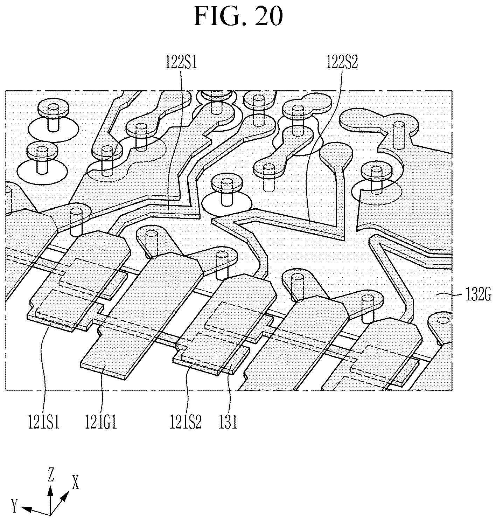

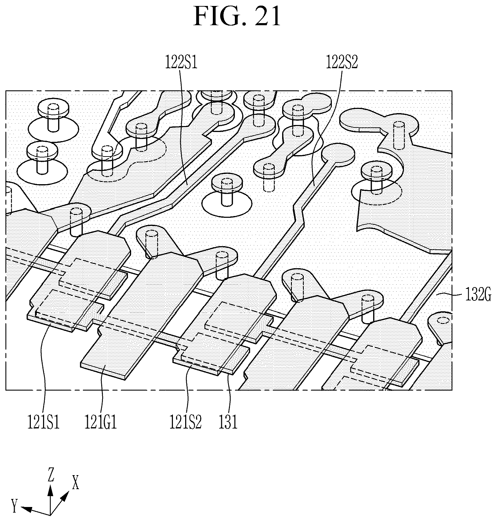

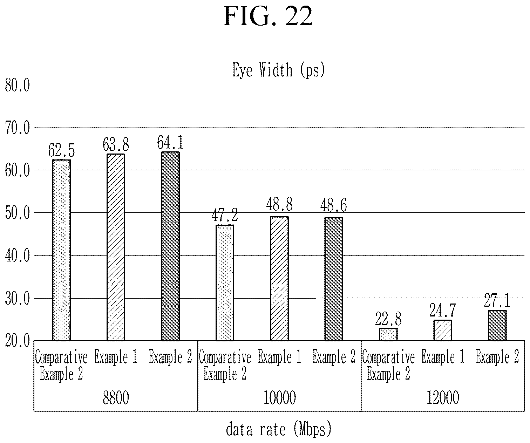

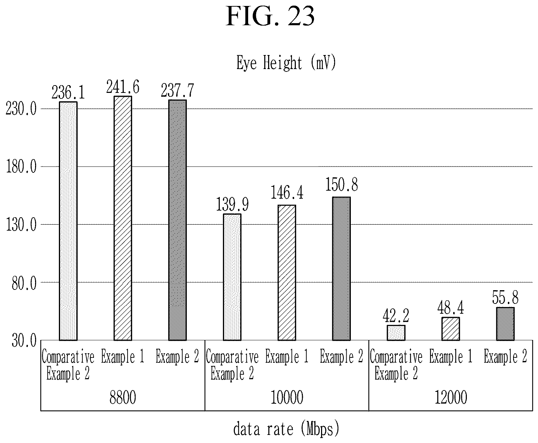

FIG. 19 illustrates a perspective view showing a partial layout of a circuit board according to Comparative Example 2. FIG. 20 illustrates a perspective view showing a partial layout of a circuit board according to Example 1. FIG. 21 illustrates a perspective view showing a partial layout of a circuit board according to Example 2. FIG. 22 and FIG. 23 illustrate eye diagrams of circuit boards according to Comparative Example 2 and Examples 1 and 2.

Instead of including a floating pattern, the circuit board of Comparative Example 2 includes an overlap pattern 132S2. The overlap pattern 132S2 is electrically connected to the second signal wire 122S2 and arranged below the second signal wire 122S2, and overlaps the first signal wire 122S1. As such, the overlap pattern 132S2 is not electrically disconnected from both the first and second signal wires 122S1 and 122S2. The overlap pattern 132S2 is formed at a same level as the floating pattern 131, e.g., at the internal wiring layer (positioned at the level L2 in FIG. 6) closest to the first terminals 121.

The circuit board according to Examples 1 and 2 includes the floating pattern 131. The floating pattern 131 of Examples 1 and 2 is formed such that the width of the region overlapping the first ground terminal 121G1 is narrower than the width of the region overlapping the signal terminals 121S1 and 121S2.

To form the overlap pattern 132S2 for generating mutual capacitance in a signal wiring region, not only is there a required change in wiring design, but there may be a problem of a limited wiring space due to the presence of the overlapping pattern 132S2.

On the other hand, when introducing the floating pattern 131 of the present disclosure, sufficient mutual capacitance between the signal terminals 121S1 and 121S2 may be secured without (in some implementations) changing a wiring design of other components, and without sacrificing sufficient wiring space. Additionally, as wiring freedom increases, a signal transfer path of the signal wires 122S1 and 122S2 may be further shortened, as in a case of Example 2 (FIG. 21).

In addition, referring to FIGS. 22 and 23, it may be seen through simulation results that circuit boards including the floating pattern 131 exhibit increased Eye Width and Eye Height values compared to Comparative Example 2, such that the floating pattern 131 may improve signal integrity (SI) of a product.

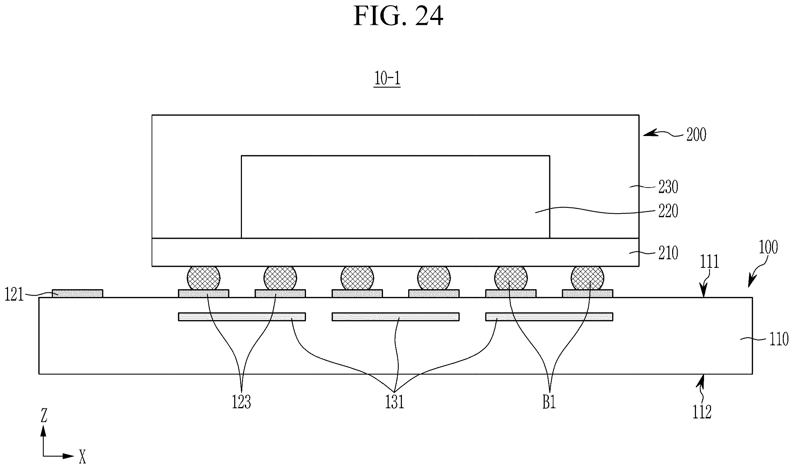

FIG. 24 illustrates another example of the use of floating patterns. In this example, the floating patterns are present in another region of a semiconductor module. In a semiconductor module 10-1, the floating pattern 131 may be positioned to overlap signal pads among upper pads 123 of the circuit board 100. The floating pattern 131 may compensate for mutual capacitance between signal pads overlapping the floating pattern 131. The floating pattern 131 of FIG. 24 can have the characteristics (e.g., geometry, arrangement, connection and disconnection characteristics, etc.) described for other floating patterns 131 throughout this disclosure, except where noted otherwise or suggested otherwise by context.

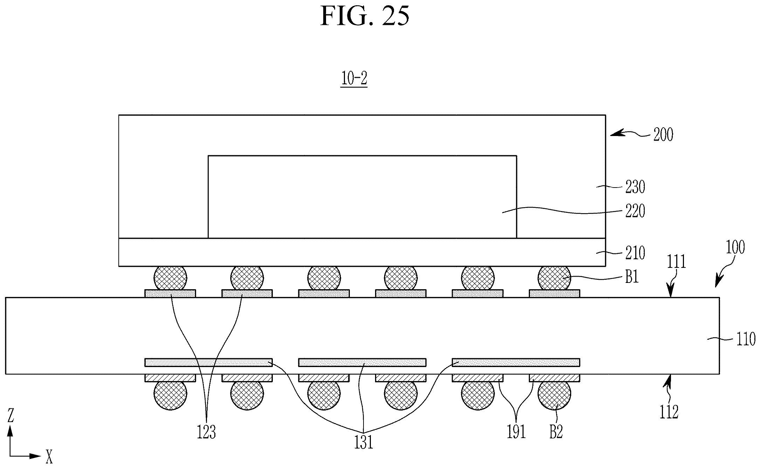

FIG. 25 illustrates another example of the use of floating patterns. In this example, the floating patterns are present in another region of a semiconductor module. A semiconductor module 10-2 may be electrically connected to other components through a conductive bump B2 positioned on a lower surface of the circuit board 100. Specifically, the conductive bump B2 may be positioned on a lower surface of lower pads 191 positioned on the second surface 112 of the insulating layer 110. The conductive bump B2 may be formed of a conductive material, e.g., a solder ball.

In the semiconductor module 10-2, the floating pattern 131 may be positioned to overlap signal pads among the lower pads 191 connected to the conductive bump B2 of the circuit board 100. The floating pattern 131 may compensate for mutual capacitance between signal pads overlapping the floating pattern 131. The floating pattern 131 of FIG. 25 can have the characteristics (e.g., geometry, arrangement, connection and disconnection characteristics, etc.) described for other floating patterns 131, 141 throughout this disclosure, except where noted otherwise or suggested otherwise by context.

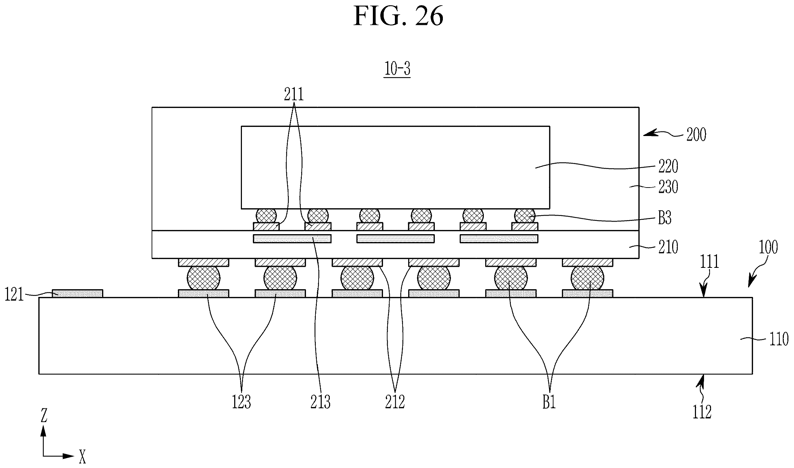

FIG. 26 illustrates another example of the use of floating patterns. In this example, the floating patterns are present in another region of a semiconductor module. As shown in FIG. 26, the floating pattern 131 may instead or additionally be applied to the semiconductor package 200. In a semiconductor module 10-3, the substrate 210 of the semiconductor package 200 may include upper pads 211 and lower pads 212. The upper pads 211 may be electrically connected to the semiconductor chip 220 through a conductive bump B3, and the lower pads 212 may be electrically connected to the circuit board 100 through the conductive bump B1.

In the semiconductor module 10-3, the floating pattern 213 may be positioned to overlap signal pads among the upper pads 211 of the substrate 210 of the semiconductor package 200. The floating pattern 213 may compensate for mutual capacitance between signal pads overlapping the floating pattern 213. The floating pattern 213 of FIG. 26 can have the characteristics (e.g., geometry, arrangement, connection and disconnection characteristics, etc.) described for other floating patterns 131 throughout this disclosure, except where noted otherwise or suggested otherwise by context.

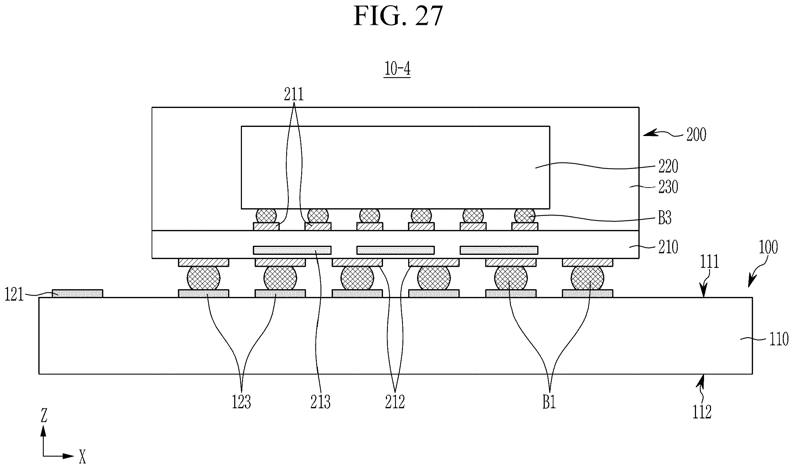

FIG. 27 illustrates another example of the use of floating patterns. In this example, the floating patterns are present in another region of a semiconductor module. Compared to the semiconductor module 10-3, in a semiconductor module 10-4, the floating pattern 213 may be positioned to overlap signal pads among the lower pads 212 of the substrate 210 of the semiconductor package 200. The floating pattern 213 may compensate for mutual capacitance between signal pads overlapping the floating pattern 213. The floating pattern 213 of FIG. 27 can have the characteristics (e.g., geometry, arrangement, connection and disconnection characteristics, etc.) described for other floating patterns 131, 141 throughout this disclosure, except where noted otherwise or suggested otherwise by context.

While this disclosure has been described in connection with certain examples, it is to be understood that the disclosure is not limited to the disclosed examples, but, on the contrary, is intended to cover various modifications and equivalent dispositions.

While this disclosure contains many specific implementation details, these should not be construed as limitations on the scope of what may be claimed. Certain features (e.g., floating pattern presence/configurations) that are described in this disclosure in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

It will be understood that the examples of the present disclosure are not independent from each other and may be implemented in combination with each other unless there is a particular conflict. For example, floating patterns described in different regions/configurations in reference to different examples may be included in the same semiconductor module. Accordingly, implementations in which examples of the present disclosure are combined should also be considered to be included within the scope of the present disclosure.

## Claims

1. A circuit board comprising:
an insulating layer (110) having a first surface (111) and a second surface (112) opposite to each other;
a plurality of first terminals (121) positioned on the first surface (111) of the insulating layer (110) and including a first signal terminal (121S1) and a second signal terminal (121S2); and
a first floating pattern (131) embedded in the insulating layer (110), the first floating pattern (131) comprising a first region overlapping the first signal terminal (121S1) and a second region overlapping the second signal terminal (121S2),
wherein the first floating pattern (131) is electrically disconnected from the first signal terminal (121S1) and the second signal terminal (121S2).

2. The circuit board of claim 1, wherein the plurality of first terminals (121) are arranged in sequence along a first direction (Y) in an edge region of the circuit board (100).

3. The circuit board of claim 2, wherein a width of the first floating pattern (131) in a second direction (X) is equal to or narrower than widths of each of the first signal terminal (121S1) and the second signal terminal (121S2) in the second direction (X), wherein the second direction (X) intersects the first direction (Y).

4. The circuit board of claim 2, wherein the plurality of first terminals (121) include a ground terminal (121G1) positioned between the first signal terminal (121S1) and the second signal terminal (121S2), wherein the first floating pattern (131) comprises a third region overlapping the ground terminal (121G1).

5. The circuit board of claim 4, wherein a width of the first floating pattern (131) in a second direction (X) in the third region is narrower than each of a width of the first floating pattern (131) in the second direction (X) in the first region and a width of the first floating pattern (131) in the second direction (X) in the second region, wherein the second direction (X) intersects the first direction (Y).

6. The circuit board of any one of claims 1 to 5, further comprising:
a plurality of second terminals (151) positioned on the second surface (112) of the insulating layer (110) and including a third signal terminal (151S1) and a fourth signal terminal (151S2); and
a second floating pattern (141) positioned at a level between the first floating pattern (131) and the plurality of second terminals (121), the second floating pattern (141) embedded in the insulating layer (110), wherein the second floating pattern (141) comprises:
a region overlapping the third signal terminal (151S1), and
a region overlapping the fourth signal terminal (151S2), wherein the second floating pattern (141) is electrically disconnected from the third signal terminal (151S1) and the fourth signal terminal (151S2).

7. The circuit board of claim 6, further comprising one or more vias (160) embedded in the insulating layer (110), the one or more vias (160) connecting the first floating pattern (131) and the second floating pattern (141).

8. The circuit board of any one of claims 1 to 7, wherein the circuit board (100) includes a plurality of internal wiring layers (WL1, WL2, WL3) embedded in the insulating layer (110), and
wherein the first floating pattern (131) is positioned at a same level as an internal wiring layer (WL1) closest to the plurality of first terminals (121) from among the plurality of internal wiring layers (WL1, WL2, WL3).

9. The circuit board of any one of claims 1 to 8, wherein an outer surface of the first floating pattern (131) is covered with the insulating layer (110).

10. A semiconductor module comprising:
the circuit board (100) according to any one of claims 1 to 9; and
one or more semiconductor packages (200) positioned on the circuit board (100).

11. A semiconductor system comprising:
a motherboard (30);
a connector (20) positioned on the motherboard (30); and
the semiconductor module (100) according to claim 10, wherein the semiconductor module (100) is coupled to the connector (20).
